(19)

Europäisches Patentamt
European Patent Office
Office européen des brevets

(11) **EP 3 879 619 A1**

(12) **EUROPEAN PATENT APPLICATION**

(43) Date of publication:
**15.09.2021 Bulletin 2021/37**

(51) Int Cl.:
*H01M 10/42* *(2006.01)*          *H01M 10/44* *(2006.01)*
*G01R 31/36* *(2020.01)*          *G01R 35/04* *(2006.01)*
*G01R 35/00* *(2006.01)*

(21) Application number: **20162438.4**

(22) Date of filing: **11.03.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Micropower ED Marketing AB**
**352 46 Växjö (SE)**

(72) Inventor: **LUNDSTRÖM, Dag**
**439 94 Onsala (SE)**

(74) Representative: **Zacco Sweden AB**
**Valhallavägen 117**
**Box 5581**
**114 85 Stockholm (SE)**

(54) **METHOD AND SYSTEM FOR CALIBRATING A CURRENT SENSOR**

(57)    The present disclosure relates to a method performed by a battery management system (105) for calibrating a current sensor (103). The battery management system (105) obtains an uncalibrated charge capacity from the current sensor (103) when it is uncalibrated. The uncalibrated charge value comprises at least one of current outflow from or current inflow to at least one battery cell (101) during at least one discharge cycle or charge cycle. The battery management system (105) obtains (202) a theoretical charge capacity from known cell capacity characteristics of the battery cell (101) during at least one discharge cycle or charge cycle. The battery management system (105) calculates (203, 304) a correction factor defined as a ratio between the uncalibrated charge capacity and the theoretical charge capacity. The battery management system (105) calibrates the current sensor (103) by adjusting a current sensor gain by means of the calculated correction factor.

100

**Fig. 1a**

EP 3 879 619 A1

**Description**

TECHNICAL FIELD

The present disclosure relates generally to a method, a battery management system and a battery system. More particularly, the present disclosure relates to calibrating a current sensor.

BACKGROUND

A desire to decrease negative consequences associated with the use of fossil fuel has resulted in a significant interest in, for example, electrified transportation and renewable energy sources. As a result, there is an increased demand of electric energy storage systems, which may serve e.g. as an intermediate energy storage or as to provide electric power within marine applications and/or to electric vehicles. Battery module systems, comprising Li-ion batteries, are a commonly used type of configuration for such applications. As such, a plurality of battery modules for storage of electric power is arranged with a battery management system which operates to control operation of the battery modules and use thereof. Moreover, a current sensor is typically arranged in the battery module system to measure current outflow from the battery modules, i.e. how much charge that is discharged from the battery modules when connected to a power-consuming means, as well as current inflow to the battery modules when being charged. Thus, for the battery module system to function properly, accurate current measurements are necessary for carrying out various functions, as mentioned above.

To achieve a sufficient accuracy in determining the state of charge of the battery modules, sufficient accuracy in other current dependent estimates etc., the current sensor has to be calibrated. This is often costly and takes time, e.g. due to production type calibration, or so called component pre-calibration. Thus, a battery module system comprises a battery management system (BMS) and a current sensor, which has been pre-calibrated and/or assembled using high accuracy manufacturing. In other words, a complete battery system is traditionally assembled to an end-user, comprising a plurality of battery modules, a BMS and an integrated and calibrated current sensor. Thus, it is desirable to be able to calibrate a current sensor of a battery system that reduces complexity of manufacturing, costs, time etc.

There is also envisaged a demand for providing battery systems as described above in an alternative manner, in which battery modules arranged with a BMS are provided separately, and such that a variety of different current sensors to be arranged with the battery modules and the BMS in a subsequent step of assembly of the battery system.

Currently, methods are based on component pre-calibration, high accuracy manufacturing of component or calibration in assembly process of batteries.

It could be beneficiary, e.g. from a cost-reduction point of view as well as in achieving a simplified assembly of the complete functioning battery system, for a user to be able to select a current sensor of their choice, and to incorporate it in the battery system.

Furthermore, it is envisaged that such current sensors, provided separately and to be arranged in the battery system, e.g. by a user of the battery system, are uncalibrated. As such, there is a need to provide alternative or different ways to calibrate such a current sensor, instead of the pre-calibration and assembly using high accuracy manufacturing, which allows to be carried out after the current sensor has been arranged in the battery module system.

Therefore, there is a need to at least mitigate or solve these issues.

SUMMARY

An object of the present disclosure is therefore to provide an approach that overcomes or ameliorates at least one of the disadvantages of the prior art, or to provide a useful alternative.

The object above may be achieved by the subject matter disclosed herein. The object above is achieved by the independent claims.

According to a first aspect, the object is achieved by a method performed by a battery management system for calibrating a current sensor. The battery management system obtains an uncalibrated charge capacity from the current sensor when it is uncalibrated. The uncalibrated charge capacity comprises at least one of current outflow from or current inflow to at least one battery cell during at least one discharge cycle or charge cycle of the at least one battery cell. The battery management system obtains a theoretical charge capacity from known cell capacity characteristics of the at least one battery cell during at least one discharge cycle or charge cycle. The battery management system calculates a correction factor defined as a ratio between the uncalibrated charge capacity and the theoretical charge capacity. The battery management system calibrates the current sensor by adjusting its current sensor gain by means of the calculated correction factor.

According to a second aspect, the object is achieved by a battery management system for calibrating a current sensor. The battery management system is adapted to obtain an uncalibrated charge capacity from the current sensor when it is uncalibrated. The uncalibrated charge capacity comprises at least one of current outflow from or current inflow to at least one battery cell during at least one discharge cycle or charge cycle of the at least one battery cell. The battery management system is adapted to obtain a theoretical charge capacity from known cell capacity characteristics of the at least one battery cell during at least one discharge cycle or charge cycle. The battery management system is adapted to calculate a correction factor defined as a ratio between the uncalibrated charge capacity and the theoretical charge capacity. The battery management system is adapted to calibrate the current sensor by adjusting a current sensor gain by means of the calculated correction factor.

According to a third aspect, the object is achieved by a battery system comprising the battery management system, at least one battery cell and a current sensor.

Thereby, it is introduced an approach by which an uncalibrated current sensor is calibrated using known cell capacity characteristics. In other words, by using known known cell capacity characteristics of the at least one battery cell provided by the battery cell manufacturer, the uncalibrated current sensor adapted to be connected to be managed by the battery management system is calibrated. Thus, by taking advantage of the known accuracy comprised in the known cell capacity characteristics, from battery cell manufacturer data, a calibration with acceptable accuracy of the uncalibrated current sensor is achieved. This has the advantageous effect of inter alia simplifying the calibration procedure as well as reducing cost related to assembly or production of the battery system.

Moreover, a method as described above has the positive effect of providing and enabling a separate selection of the current sensor to be comprised in the battery system. Another advantage of the present disclosure is that the battery system may initially be provided to the user without the current sensor. Later on, the user may select the current sensor, arrange it in the battery system and use the present method to calibrate it. The present method assists in calibrating the current sensor of a battery system by using the known cell capacity characteristics. This has the advantage that an uncalibrated current sensor can be used when assembling a battery system, which has positive effects such as being both time and cost-efficient, as well as providing an easier alternative to provide and assemble a battery system. That is, since the battery cells, and the battery modules if present, may be supplied separately and then leaving the option free to choose a (any) current sensor when assembling the battery system. The battery management system arranged to be connected to the battery cells can then, by using the known characteristics of the battery cells, be used to calibrate the current sensor, using the herein described method.

The present disclosure is not limited to the features and advantages mentioned above. A person skilled in the art will recognize additional features and advantages upon reading the following detailed description.

BRIEF DESCRIPTION OF THE DRAWINGS

The present disclosure will now be further described in more detail in the following detailed description by reference to the appended drawings in which:

Fig. 1a    is a schematic block diagram illustrating a battery system.
Fig. 1b    is a schematic block diagram illustrating a battery system.
Fig. 2     is a flowchart depicting a method.
Fig. 3     is a flowchart depicting a method.
Fig. 4     is a graph illustrating battery cell characteristics.

In the drawings and the following detailed description, like reference characters refer to like elements. It should be noted that the appended drawings are not necessarily drawn to scale and that the dimensions may have been exaggerated for the sake of clarity. Emphasis is instead placed upon illustrating principles.

DETAILED DESCRIPTION

In the following, which relate to a battery management system and use thereof, there will be disclosed an approach for calibrating a current sensor by means of using known cell capacity characteristics of at least one battery cell. The battery management system and the current sensor may be comprised in a battery system.

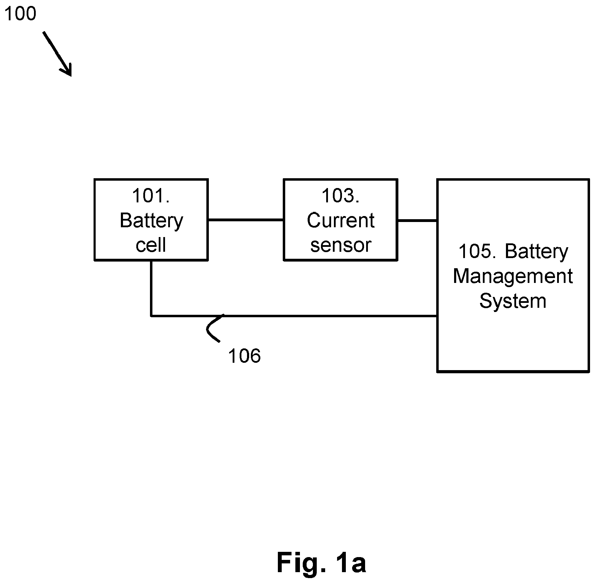

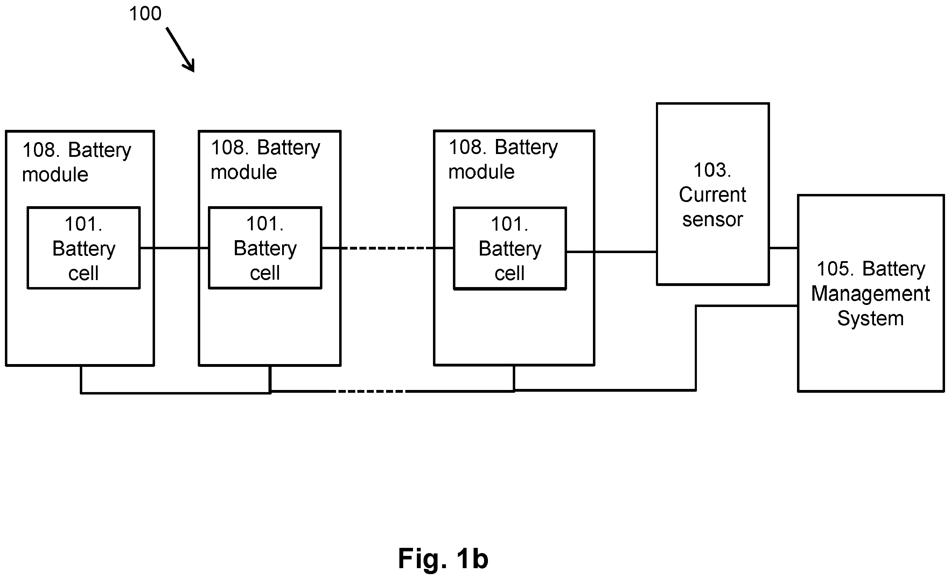

**Fig. 1a** is a schematic block diagram illustrating a **battery system 100.** The battery system 100 comprises at least one **battery cell 101.** The at least one battery cell 101 is adapted to store and produce electrical energy used for powering devices. The at least one battery cell 101 is a chargeable battery cell. The at least one battery cell 101 may be for example a lithium-ion battery cell, a lithium-sulfur battery cell, supercapacitor battery cells, e.g. graphene, aluminum-graphite battery cell, bio-electrochemical battery cells, thin film battery cells, solid state battery cells, etc. The at least one battery cell 101 may be described as a smallest unit for electrochemical energy storage, where electrical energy is derived from the insertion/extraction reactions of lithium ions or oxidation/reduction reaction of lithium between the negative electrode and the positive electrode. The at least one battery cell 101 may be referred to as a battery, for the sake of simplicity. The at least one battery cell 101 has known cell capacity characteristics, e.g. discharging characteristics, or charging characteristics or both, which will be described in further detail below. Knowing the cell capacity characteristics for a battery cell 101, e.g. voltage versus charge data, it should be understood that this data may be combined to provide corresponding data for a plurality of connected battery cells 101 of a **battery module 108** (not shown in fig. 1a, but in fig. 1b), i.e. corresponding voltage and charge data may be achieved on a battery module level.

A battery's cell's capacity may be described as the amount of electric charge which the battery cell 101 can deliver at a rated voltage. Cell capacity is measured in amph hour (Ah).

The at least one battery cell 101 shown in fig. 1a may be comprised in a battery module 108 which will be described in more detail below with reference to fig. 1b.

The battery system 100 comprises a **current sensor 103.** The current sensor 103 is adapted to be connected to the at least one battery cell 101 via a wired or wireless connection. The current sensor 103 may be any suitable current sensor adapted to sense at least one of current flowing in to and current flowing out, or both, of the at least one battery cell 101. Using other words, the current sensor 103 is a device adapted to detect electric current to and from the at least one battery cell 101. The current sensor 103 is used to determine how much inflow of charge (charge, current) and outflow of charge (discharge, current) to and from the at least one battery cell 101.

The current sensor 103 is arranged in the battery system 100 such that the current inflow to and current outflow from the at least one battery cell 101 may be determined.

The current sensor 103 may be adapted to generate a signal associated with the sensed current, and this signal may be analog or digital. The current sensor 103 may be for example a shunt sensor, also referred to as an ammeter shunt, a current transformer, Rogowski coil, magnetic-field based transducer etc.

The battery system 100 comprises a **battery management system 105.** The battery management system 105 is adapted to be connected to the current sensor 103 via a first link which may be wired or wireless. The battery management system 105 is adapted to be connected to the at least one battery cell 101 via a **second link 106.** The second link 106 may be a wired or wireless link. The second link 106 may be a communication bus such as e.g. a RS485 type (multidrop) communication bus, a Controller Area Network (CAN) bus, it may be any suitable wireless link which uses any suitable protocol depending on type and level of layer, e.g. as indicated by the Open Systems Interconnection (OSI) model etc.

The battery management system 105 is adapted to manage the at least one battery cell 101 and possibly also the whole battery system 100, for example by calibrating the current sensor 103. The battery management system 105 coordinates when and how the battery system 100 may be used by an application, such as a vehicle or a machine. In other words, the battery management system 105 functions as a control unit controlling the battery system 100 and its interaction with the application it is supposed to provide electric power to. Thereby, the battery management system 105 communicates with and receives information from the current sensor 103 and the at least one battery cell 101.

The battery management system 105 uses measurements from the current sensor 103 for various purposes. One purpose may be to determine, based on the uncalibrated charge capacity, that the amount of current flowing in or out is allowed and not dangerous to the at least one battery cell 101, e.g. with respect to over heading, malfunctioning etc. Another purpose may be to determine the total State Of Charge (SOC) of the at least one battery cell 101 based on the measurements from the current sensor 103 together with cell voltages and cell temperatures, also measured by the current sensor 103.

SOC is a measure of the amount of charge available in the at least one battery cell 101 or in the battery module 108. It may be reported in % of a reference value, which may be the fully charged battery at any time during the battery life time. This means that the amount of charge corresponding to a change in SOC of e.g. 1% varies over the battery life. The SOC may be used by the application to calculate the present energy content of the battery cell 101, in order to predict how much energy may be discharged and charged. It is also one of the parameters that are used to limit the operation of the battery cell 101 outside the zone of optimum life.

The battery management system 105 may be co-located with the at least one battery cell 101 and the current sensor 103, or it may be located at different location. For example, the at least one battery cell 101 and the current sensor 103 may be located in a production area of a factory and the battery management system 105 may be located in a control room of the factory. In another example, the at least one battery cell 101, the current sensor 103 and the battery management system 105 may be located within one casing, cabinet, box or central system and comprised in e.g. a vehicle. In a further example, the at least one battery cell 101 may be located in a first position inside a vehicle, the current sensor 103 may be located in a second position in a vehicle and the battery management system 105 may be located at a third position in the vehicle. The battery management system 105 may be a processor of the battery system 100.

The battery management system 105 may be an electronic control board that is used to coordinate when and how the application consuming the electrical power can use the battery system 100. It may be used as an electronic interface to the application to which the battery system 100 provides electrical power. The battery management system 105 may be the system that may need the accurate current to do calculations such as to determine that the amount of current is allowed and not dangerous, to determine the total battery SOC etc.

The battery management system 105 and the current sensor 103 may be comprised in or connected to a control system. The battery management system 105 may be adapted to collect the information about the at least one battery cell 101 and the current sensor 103, and to take decisions of when to allow or how much charge, or how much discharge to be provided to or from the at least one battery cell 101.

The battery system 100 comprises an input connector and an output connector for connection to e.g. the application to which the battery system 100 is adapted to deliver electrical energy, a charging device for charging the battery system 100 etc.

**Fig. 1b** illustrates the battery system 100 comprising a plurality of battery cells 101, which is different from fig. 1a which shows one battery cell 101. The plurality of battery cells 101 may be serially connected or connected in parallel. The plurality of battery cells 101 may be comprised in one or more **battery modules 108.** The battery module 108 comprises one or a plurality of battery cells 101 which form a storage unit for electrical energy of the battery module 108. Each battery module 108 may comprise for example 36, 52 or 72 battery cells 101, corresponding to 105, 150 or 210 Ah connected in parallel. Each battery module 108 may comprise any other n number of battery cells 101, where *n* is a positive integer.

The battery module 108 may be referred to as a battery pack, a pack comprising a plurality of battery cells 101 etc. The battery module 108 may be described as an energy storage device, which is comprised of electrically connected battery cells 101 or modules. It may incorporate a protective housing and be provided with terminals or other interconnection arrangement. It may include protective devices and control and monitoring.

The battery module 108 may comprise a casing, housing, cabinet, box or similar in which the plurality of battery cells 101 are comprised. The casing, cabinet or box may be made of any suitable material such as e.g. plastic, metal, steel, etc. The casing, housing cabinet or box may be designed such that a plurality of battery modules 108 may be stackable. The casing, housing cabinet or box may be adapted to be transparent, at least partly transparent or non-transparent. The battery module 108 may be sealed in order for the user not to open it and tamper with the content of it, or the battery module 108 may be non-sealed such that the user is able to open it e.g. in the need for searching for errors, replacing battery cells 101 etc.

The battery module 108 may have a voltage in the range of for example 4.07V - 2.5V. The battery module 108 may have a capacity of for example 105Ah, 150Ah or 210Ah.

In fig. 1b, it is shown that each battery module 108 comprises one battery cell 101, but each battery module 108 may comprise two or more battery cells 101. If there are multiple battery modules 108, then each battery module 108 may comprise the same or different number of battery cells 101. If two or more battery cells 101 are comprised in a battery module 108, then these two or more battery cells 101 may be connected in parallel or series and arranged such that a single charge inflow to and outflow from the battery module 108 is achieved, which represents the combined contribution of the connected battery cells 101. The multiple battery modules 108 are adapted to be serially connected. The last battery module 108 in the series is adapted to be connected to the current sensor 103. All battery modules 108 are adapted to be connected to the battery management system 105.

The at least one battery cell 101 in the battery system 100 may be connected to each other via welding. The at least one battery cell 101 in a battery module 101 may be connected to each other via a welding configuration, yielding a total voltage corresponding to the typical voltage of an individual battery cell 101. The number of battery cells 101 varies with the type of battery module, yielding different capacities.

Each battery module 108 may comprise a battery management unit (not shown) respectively, adapted for determining voltage and temperature of the at least one battery cell 101 within the battery module 108. The battery management unit which may be comprised in the battery module 108 may be an electronic subsystem which may measure battery module voltages and temperatures. The battery management unit may communicate with the battery management system 105 or with a part of the battery management system 105. The communication may be done via a communication bus, wired or wireless.

When there is a plurality of battery cells 101 comprised in a battery module 108, then the battery cells 101 may be arranged in rows. The number of battery cell rows, and hence the height of the battery module 108 may vary depending on its specified capacity.

An advantage of incorporating the at least one battery cell 101 in a battery module 108 may be that it facilitates modularity. Another advantage of a battery module 108 may be that the user does not have to understand or know what's inside the battery module 108, e.g. the number of battery cells 101 comprised in the battery module 108, but he can select a battery module 108 only based on the needed performance without considering how the performance is achieved. If battery modules 108 have a standardized or the same type of connection point and possibly also the same casing design, it may be easy to connect a plurality of battery modules 108 to each other. A battery module 108 may be an advantage in that it may be easy to replace a battery module 108 for example in case of an error, in case of a need for replacing it with a different type of battery module, e.g. with different charging capacity etc.

If the at least one battery cell 101 is not comprised in a battery module 108, then the weight may be reduced since there is no casing around the battery cell 101 as compared to the battery module 108.

A battery module 108 may comprise components such as a cooling system, a heating system, a temperature sensor etc.

The battery system 100 may comprise other units such as e.g. a fuse, a switch, a power switch, a relay, a memory, input interfaces, output interfaces, busses, temperature sensors, cooling system heating system, clock, power connector etc., which are not illustrated in fig. 1a and fig. 1b. For example, the fuse may be used as last method of disconnection if there is an external short circuit that needs to be protected against. A power switch enables the battery system 100 to be disconnected from the external machine or vehicle when the battery management system 100 signals to the switch or a relay or to be opened. The disconnect action is often used due to the fact that:

a) the battery system 100 or at least a part of the battery system 100, e.g. the at least one battery cell 101, has an imminent fault,
b) the battery system 100 or at least a part of the battery system 100, e.g. the at least one battery cell 101, has a state of charge below a predetermined value, e.g. a low state of charge,
c) the battery system 100 or at least a part of the battery system 100, e.g. the at least one battery cell 101, is commended by the vehicle or machine to disconnect.

The battery system 100 may or may not have a protective housing. The protective housing may be made of any suitable material such as e.g. plastic, metal, steel etc.

The battery system 100 may comprise an interface towards a charger. The charger may be an integrated charger which is integrated in the battery system 100 or it may be an external charger adapted to be connected to the battery system 100.

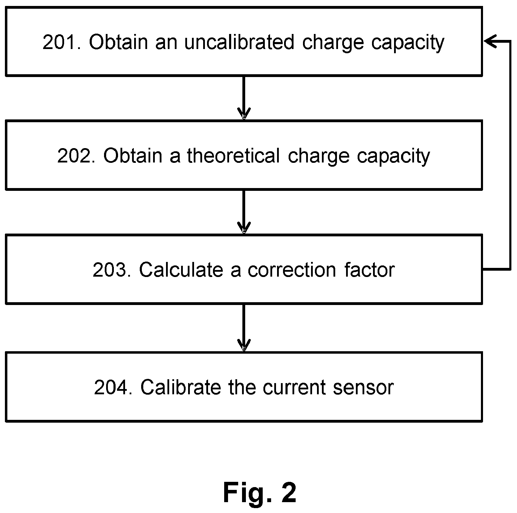

Fig. 2 is a flow chart illustrating a method performed by the battery management system 105 for calibrating the current sensor 103.

Before performing the first step of the method, it may be assumed that there is a certain minimum accuracy in the current sensor 103, i.e. a minimum accuracy of the current which is sensed or measured by the current sensor 103. This accuracy may be referred to as a predetermined accuracy, a manufacturer accuracy etc. It may be assumed that the at least one battery cell 101 is new and have a known charge accuracy. At least one battery cell 101 may be considered to be new when it has not been previously used or when it has only been previously used a certain number of times, e.g. by the manufacturer when testing that the at least one battery cell 101 is functioning before providing it to the user.

It may be assumed that the battery module 108 and therefore the at least one battery cell 101 have been, at start of the method, charged to a first charge level or discharged to a second charge level. The first charge level is higher than the second charge level. The first charge level may be full charge or partly charge. The first charge level may be above 0% charge. The first charge level may not be zero charge, i.e. an empty cell. The second charge level may be partly charge or zero charge. When the at least one battery cell 101 has zero charge, then it may be referred to as an empty battery cell. The second charge level may be below 100% charge. The second charge level may not be a 100% charge level.

The method comprises at least one of the following steps to be performed by the battery management system 105, which steps are performed in any suitable order than described below:

Step 201

The battery management system 105 obtains an uncalibrated charge capacity from the current sensor 103 when it is uncalibrated. The uncalibrated charge capacity comprises at least one of current outflow from or current inflow to at least one battery cell 101 during at least one discharge cycle or charge cycle of the at least one battery cell 101. The uncalibrated charge capacity may be referred to as an uncalibrated total charge capacity.

The at least one battery cell 101 may be a lithium-ion battery cell, a lithium-sulphur battery cell, supercapacitor battery cell, e.g. graphene, aluminium-graphite battery cell, bio-electrochemical battery cell, thin film battery cell, solid state battery cell, etc.

When the current sensor 103 is uncalibrated, the steps 202-204 have not been performed. In other words, the current sensor gain of the current sensor 103 has not been adjusted by means of any calculated correction factor. The current sensor 103 may referred to as being uncalibrated when it is new, i.e. when it has not been previously used, when the current sensor gain has not been corrected or adjusted. The current sensor 103 may be have been pre-calibrated by the manufacturer, but the current sensor 103 is considered to be uncalibrated, even though it has been pre-calibrated. Thus, the pre-calibration may be neglected.

A charge cycle may be charge of the at least one battery cell 101 until the first charge level or until duration of the charge procedure lasted longer than a first time period. A discharge cycle may be discharge of the at least one battery cell until the second charge level or until duration of the discharge procedure has lasted longer than a second time period. As mentioned above, the first charge level is higher than the second charge level. The first charge level may be full charge or partly charge. The second charge level may be partly charge or zero charge.

The uncalibrated charge capacity may be obtained until a cell charge is lower than a known cell charge, the known cell charge may be a known lowest allowed cell charge.

This step 201 may be initiated when the current outflow or inflow obtained from the current sensor 103 is below a predetermined value, and possibly during a predetermined time interval, which may be detected by the battery management system 101.

Step 201 may also be described as the battery management system 101 performs multiple measurements of uncalibrated current over time and accumulates these.

Step 201 may be repeated and performed, during discharge, until the battery cell charge is lower than a second cell charge level, i.e. until the battery cell voltages are lower than a known second cell voltage. The second cell charge level may be predetermined. The second cell charge level may be referred to as a lowest allowed cell charge or a minimum cell charge. Second cell charge level may be referred to as an uncalibrated charge capacity, a final capacity or a second capacity.

Step 201 may be repeated and performed until the battery cell charge has reached or is above a first cell charge level during charge, i.e. until the battery cell voltages has reached or is above a first cell charge level, e.g. a first cell voltage. The first cell charge level may be predetermined. The first cell charge level may be referred to as a highest allowed cell charge or a maximum cell charge. The first cell charge level may be referred to as an uncalibrated charge capacity, a charge capacity, a final capacity or a first capacity.

The uncalibrated charge capacity is obtained during actual discharge or charge of the at least one battery cell 101, and is an actual charge capacity. This is in contrast to the theoretical charge capacity described below in step 202.

Step 202

The battery management system 105 obtains a theoretical charge capacity from known cell capacity characteristics of the at least one battery cell 101 during at least one discharge cycle or charge cycle. The theoretical charge capacity may be referred to as a theoretical total charge capacity.

The known cell capacity characteristics may comprise at least one of:

- a known cell charge capacity,
- a known cell discharge capacity,
- a cell voltage versus cell discharged charge in a range between a first charge level and a second charge level, e.g. a fully charged cell and an empty cell, and
- a cell voltage versus cell charged charge in a range between the second charge level and the first charge level, e.g. an empty cell and a fully charged cell.

The first charge level may be higher than the second charge level.

The theoretical charge capacity may be a charge capacity obtained from or derived from the known cell characteristics as a total amount of charge discharged from the at least one battery cell 100 from the first charge level to the second charge level, or a total amount of charge charged to the at least one battery cell 101 from the second charge level to the first charge level. For example, the theoretical charge capacity may be a charge capacity obtained from the known cell characteristics as a total amount of charge discharged from a fully charged cell to an empty cell or as a total amount of charge charged to an empty cell and until a fully charged cell.

The method may thus be performed using a discharge cycle, i.e. obtaining the amount of current outflow through the current sensor 103 from a charged battery cell 101 to a discharged battery cell 103, or, vice versa, using a charge cycle, i.e. obtaining the amount of current inflow through the current sensor 103 from an empty cell to a charged cell 101. A discharge cycle may be a full discharge cycle, or a partly discharge cycle, e.g. discharged to the second level. A charge cycle may be a full charge cycle or a partly charge cycle, e.g. charged to the first level.

By using a discharge or charge cycle, an advantage may be that the known cell charge capacity is used. As recited above, the cell charge capacity is known and fixed to certain tolerance from the battery cell manufacturer.

The theoretical charge capacity may be obtained until a cell charge is lower than a known cell charge. The known cell charge may be a known lowest allowed cell charge or cell voltage

Step 202 may be described as using the cell manufacturer data for the at least one cell 101 to calculate the theoretical charge capacity based on the same charging method and the same known cell charge.

The theoretical charge capacity is theoretical in that it is stated or pre-defined by the battery cell manufacturer. The theoretical charge capacity may be obtained, e.g. from a data sheet associated with the at least one battery cell 101. The theoretical charge capacity may be the same as the actual or real charge capacity or it may be different from the actual charge capacity. The theoretical charge capacity is not derived during testing of the battery cell 101, e.g. during charge or discharge, but it may be mathematically calculated based on e.g. the size and composition of the at least one battery cell 101.

Step 203

The battery management system 105 calculates a correction factor. The correction factor is defined as a ratio between the uncalibrated charge capacity and the theoretical charge capacity.

Steps 201-203 may be carried out for N at least one of discharge and charge cycles, where N is a positive integer.

The battery management system 105 may calculate an accumulated correction factor based on the calculated correction factor in each cycle of the N at least one of discharge and charge cycles.

The accumulated correction factor may be calculated by using a filter. The filter may be a linear filter or a non-linear filter. The filter may be a recursive filter, e.g. a 1 pole recursive filter, or any other suitable filter adapted to enable calculation of the accumulated correction filter. A 1 pole recursive filter may be referred to as a single pole recursive filter. An advantage of a recursive filter is that it may be easily tuned

An accumulated correction factor may be calculated based on the calculated correction factor in each cycle of the N at least one of discharge cycle and charge cycle. The correction factor is accumulated in that the correction factor for each cycles is accumulated, e.g. they are added to each other. The accumulated correction factor may be an average correction factor, and this may be an average of the correction factor for the N at least one discharge cycle and charge cycle.

By applying the method illustrated in fig. 2 to a series of at least one of charge cycle and discharge cycle, any type of measurement noise or error may be reduced. The term "series" refers to N number of cycles, where N is a positive integer.

When applying a series of at least one of discharge cycle and charge cycle, in order to minimize or reduce any measurement noise or error associated with the uncalibrated charge capacity, the theoretical charge capacity and the correction factor, the method may comprise to initiate step 201 only when the current inflow to or outflow from the at least one battery cell 101 is below a predetermined current value. The predetermined current value may be during a predetermined time interval. In this way, the battery cell voltage may with higher accuracy correspond to the battery cell Open Circuit Voltage (OCV) voltage and thus improve accuracy in retrieving the corresponding battery cell charge capacity.

OCV, also referred to as $V_{OC}$, may be described as is the difference of electrical potential between two terminals of a device when disconnected from any load. There is no current flow in an open circuit, but there is voltage. OCV may be described as representing a full voltage of a voltage source.

The correction factor may be as follows:

$$Correction\ factor = \frac{\text{Uncalibrated charge capacity}}{\text{Theoretical charge capacity}}$$

The correction factor may also be referred to as a calibration factor.

Step 204

The battery management system 105 calibrates the current sensor 103 by adjusting the current sensor gain of the current sensor 103 by means of the calculated correction factor. The battery management system 105 may calibrate the current sensor 103 by providing the current sensor gain to the current sensor 103 or by applying the current sensor gain to output from or input to the current sensor 103.

The current sensor gain may be further adjusted by means of the accumulated correction factor.

The purpose of calibrating the current sensor 103 may be to increase the accuracy of the current measurements.

Calibration may also be referred to as tuning, setting, adjusting, regulating etc.

From the correction factor in step 203, the calibrated current for the current sensor 103 may be as follow:

$$I_{callibrated} = I_{uncalibrated} \times \frac{\text{Theoretical charge capacity}}{\text{Uncalibrated charge capacity}}$$

The correction factor may be updated with several small steps over time to minimize the impact of any one potentially noisy measurement made by the current sensor 103, for example:

$$Y(n + 1) = Y(n) \cdot a + X(n)(1 - a)$$

where a may be 0.9, and where n is a time step.

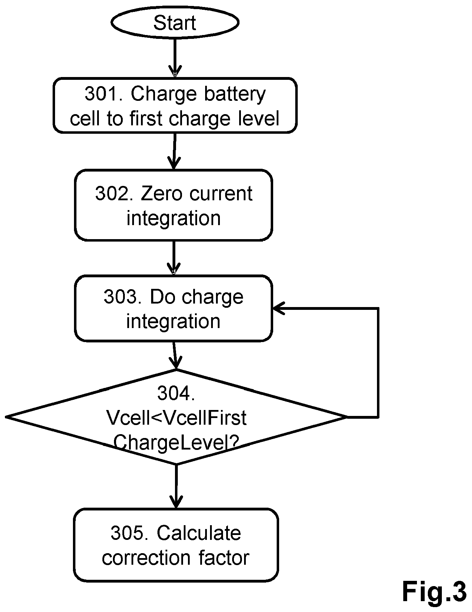

The method above will now be described with reference to **fig. 3.** Fig. 3 is a flow chart illustrating the method performed by the battery management system 105. The method comprises at least one of the following steps to be performed by the battery management system 105, which steps are performed in any suitable order than described below:

Step 301

The at least one battery cell 101 is charged to a first charge level, e.g. 100% charge, 90% charge, full charge etc. This may be described as

$$V_{cell}(OCV) = V_{cellFirstChargeLevel}$$

In other words, the voltage of the at least one battery cell 101 at OCV is equal to the voltage when the at least one battery cell 101 is charged to the first charge level.

Step 302

Zero current integration may be performed. This may be described as:

$$C_{int} = 0.$$

Step 303

In this step, the charge integration may be performed. This may be described as:

$$C_{int} = \int i(t)dt$$

, where $i(t)$ is the current at time $t$.

Step 304

In this step, the battery management system 105 may check if the at least one battery cell 101 is below the first charge level, e.g. if it is fully charged or empty, i.e. it checks if $V_{cell} < V_{cellFirstChargeLevel}$. Here it may be assumed that $i(t)$ has been low for a predetermined amount of time. This may ensure that $V_{cell}$ is close to $V_{cell}(OCV)$, i.e. to the voltage of the at least one battery cell 101 at OCV.
Steps 301-34 correspond to steps 201-203 in fig. 2.

Step 304

This step corresponds to step 204 in fig. 2. In this step, the correction factor K is calculated. The correction factor K may be calculated as follows:

$$K = \frac{C_{int}}{Cell\ capacity\ BOL}$$

$C_{int}$ is the integrated charge.
*Cell capacity BOL* is the cell capacity of the at least one battery cell 101 at Beginning of Life (BOL).
Calculation of the correction factor *K* may be applied to a series of N charge cycles or discharge cycles in order to minimize any type measurement error. N may be any positive integer, e.g. 10. This may be be done with a 1 pole recursive filter like

$$K_{tot}(n) = K_{tot}(n-1) * alfa + K(n) * (1 - alfa)$$

, where alfa is between 0 and 1 depending on how fast the new values of $K$ should be weighted.

When N charge or discharge cycles have been retrieved, the $K_{tot}$ value, i.e. the accumulated correction factor or the total correction factor, may be used to adjust the current sensor gain G. Assuming that the measured current $i(t)$ = $G . I_{measured}$. When inserting the correction factor $K_{tot}$, the calibrated current $i_{calib}$ at a time instance $t$ may be as follows:

$$i_{calib}(t) = \frac{G}{K_{tot} \cdot i_{meas}}$$

G is the sensor gain
$K_{tot}$ is the total or accumulated correction factor.
$i_{meas}$ is the current measured by the current sensor 103.
$t$ is the time.
$i_{calib}$ is the calibrated current.

The method described above will now be described with an example where there are 10 number of points in the discharge cycle, i.e. N=10 as an example. 10 measurements are taken in a discharge cycle. The example is equally applicable to 10 number of charge cycles. The method comprises at least one of the following steps 1)-9), which steps may be performed in any suitable order than described below:

1) Charge the at least one battery cell 101 to a first charge level. Assume $V_{cell} = V_{cellFirstChargeLewvel}$

2) The following fucntion is defined: $Jk = \frac{k*(Cell\ capacity\ BOL[Ah])}{N}$

3) Set $c_{int} = 0$, $k = 1$. The integration is set to zero when the at least one battery cell 101 is charged to the first charge level.

4) $c_{int}(t) = \int_0^t i(t)dx$. In this step, the at least one battery cell 101 is used, i.e. discharged during a normal operation.

5) If $i(t) < i_{low}$ and $C_{int}(t) > J_k$, then set $V_k = V_{cell}(t)$, $C_k = ci_{nt}(t)$, $k = k + 1$

6) If $k \leq N$, then step 4) is performed.

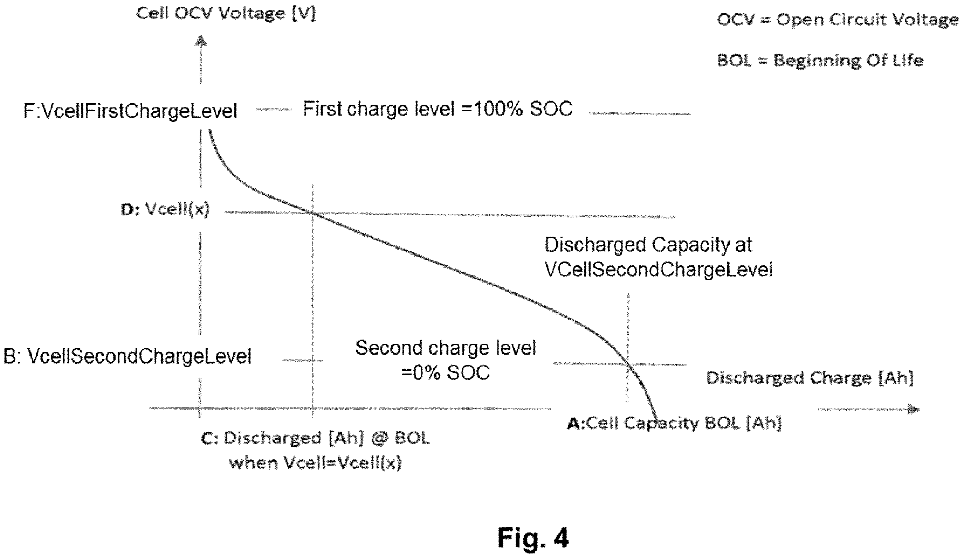

7) Calculate $D_k = f(V_k)$ where $f(x)$ is the function from voltage to discharged capacity, i.e. to the second charge level, as seen in point D and C in fig. 4 (described below).

8) Calculate the Leastsquare fit: $K_{tot} = argmin \sum_1^N (K * D_k - c_k)^2$

9) Set the new $i_{calib}(t) = \frac{G}{K_{tot} \cdot I_{meas}}$

The above described method may be combined with a requirement to use more than one cycle and thus slowly adjust the $K_{tot}$ to the new data and become even more independent of e.g. measurement noise associated with the current sensor 103.

There may be one or more prerequisites for the present disclosure. These will now be described with reference to the graph illustrated in **fig. 4.** Fig. 4 illustrates an example of a charge capacity for at least one battery cell 101. The x-axis of fig. 4 represents the discharged charge measured in Ah. The y-axis of fig. 4 represents the cell OCV voltage measured in V.

A prerequisite may be that the at least one battery cell 101 may have a total cell charge capacity (Ctot) that is known and possibly with a known tolerance or accuracy. The total cell charge capacity, Ctot, may be defined as the amount of current, e.g. integrated current, from a battery cell 101 charged to the first charge level (e.g. full cell), see point F in fig. 4, to a battery cell 101 charged to the second charge level (e.g. empty cell), see the crossing between points A and B in fig. 4. As mentioned above, the first charge level is higher than the second charge level. The first charge level may be full charge and the second charge level may be zero charge, i.e. empty cell. When the cell voltage reaches the B point, then it is equal to OCV, VcellSecondChargeLevel, a new battery cell 101 has at this point discharged a known amount of integrated current, see point A, aka cell capacity at BOL. This accumulated or integrated current is known and fixed to a certain tolerance from the battery cell manufacturer. This is valid in both directions charge or discharge of the at least one battery cell 101.

Another prerequisite may be that the at least one battery cell 101 has a known OCV versus discharge characteristic for every point between a battery cell 101 at the first charge level and a battery cell 101 at the second charge level, and at BOL. For each position during a discharge cycle the battery management system 105 may obtain pairs of Voltages Vk and discharged integrated current Ck. It may be obtained so that the pairs are collected spread out over range from the first charge level to the second charge level of the at least one battery cell 101. For example, only one point (Vk, Ck) may be collected in each 1/10 of the discharge range. This method is valid in both directions, i.e. in both charge and discharge of the at least one battery cell 101.

The present disclosure takes advantage of using at least one battery cell 101 in the battery system 100, with known charge accuracy and discharging characteristics, when calibrating the current sensor 103 arranged in the battery system 100. The known charge accuracy and discharging characteristics are data available from battery cell manufacturers. Fig. 4 illustrates an exemplifying discharging characteristic of at least one battery cell 101. The at least one battery cell 101 has known OCV versus discharged charge for every point between the first charge level to the second charge level, e.g. from a fully charged cell to an empty cell.

The cell charge capacity of the at least one battery cell 101 may be defined as the amount of charge from a battery cell 101 with a first charge level, see point F, to a battery cell 101 with a second charge level, see crossing between A and B. When the cell voltage reaches the B point then it is equal to the OCV Voltage (VcellSecondChargeLevel) of a battery cell 101 with the second charge level and at this point, a known amount of integrated current has been discharged, see point A, which amount is the battery cell capacity. This accumulated or integrated current, charge, is known and fixed to a certain tolerance from the battery cell manufacturer and represents the characteristics of the battery cell 101 as new, i.e. in BOL.

As the at least one battery cell 101 ages, inter alia by means of being repetitively discharged and charged, the cell characteristics change and/or deteriorate. Thereby, the known cell capacity characteristics have acceptable accuracy based on that the battery cells 101, i.e. the battery module, is defined as being in BOL. Hence, the at least one battery cell 101 may not have been discharged and/or charged more than x times, where x is any suitable positive integer.

As mentioned earlier, the known cell capacity characteristics may comprise battery cell voltage versus charge data for every point between a battery cell 101 at the first charge level and a battery cell 101 at the second charge level. In this case, a discharge or charge cycle of the at least one battery cell 101, independent of the state of charge of the at least one battery cell 101 at beginning and/or end of the cycle, is used for the calibration of the current sensor 103. This has the advantage of not having to fully discharge or fully charge the at least one battery cell 101 during the calibration of the current sensor 103. By way of example, referring to Fig. 4 again, a discharge cycle resulting in a remaining battery cell (OCV) voltage indicated by letter D gives a corresponding discharged charge capacity indicated by letter C.

The battery system 100 may be adapted to provide electric power to any suitable device which consumes electrical power. An electric vehicle may be an example of a device and may refer to any electrically propelled vehicle. The vehicle may refer to a vehicle at least partly supporting autonomous driving. The battery system 101 may form a charging station for an electric vehicle. The battery system 101 may be adapted for powering propulsion of a vehicle. The vehicle, which may comprise the battery system 100, may refer to any electrically driven vehicle, such as a land vehicle or a marine vessel. The battery system 100 may be adapted to provide electric power to vehicles, busses, boats, industrial applications, forklifts, trucks, Automated Guided Vehicles (AVG), machines such as e.g. mining machines, cleaning machines, construction machines, medical devices, power plants, wind turbines, communication equipment etc.

The present disclosure may be summarized as follows:
A method performed by a battery management system 105 for calibrating a current sensor 103. The method comprises at least one of the following steps, which steps may be performed in any suitable order than described below:

Step a)

This step corresponds to step 201 in fig. 2. The battery management system 105 obtains an uncalibrated charge capacity from the current sensor 103 when it is uncalibrated. The uncalibrated charge value comprises at least one of current outflow from or current inflow to at least one battery cell 101 during at least one discharge cycle or charge cycle of the at least one battery cell 101.

The discharge cycle in step a) may be discharge of the at least one cell 101 to a second charge level. The charge cycle may be charge of the at least one battery cell 101 to a first charge level. The first charge level may be higher than the second charge level.

The uncalibrated charge value may be obtained until a battery cell charge is lower than a known cell charge or until duration of at least one of the charge cycle or discharge cycle has lasted longer than a time period.

Step a) may be initiated when the current outflow or inflow obtained from the current sensor 103 is below a predetermined value during a predetermined time interval.

### Step b)

This step corresponds to step 202 in fig. 2. The battery management system 105 obtains a theoretical charge capacity from known cell capacity characteristics of the at least one battery cell 101 during at least one discharge cycle or charge cycle.
The known cell capacity characteristics may comprise at least one of:

*    a known cell charge capacity,
*    a known cell discharge capacity,
*    a cell voltage versus cell discharged charge in a range between a first charge level and a second charge level, wherein the first charge level is higher than the second charge level, and
*    a cell voltage versus cell charged charge in a range between the second charge level and the first charge level.

The theoretical charge capacity in step b) may be a charge capacity obtained from the known cell characteristics as an amount of charge discharged from the at least one battery cell 101 from the first charge level to the second charge level, or as an amount of charge charged to the at least one battery cell 101 from the second charge level and to the first charge level.
The theoretical charge value may be obtained until a battery cell charge is lower than a known cell charge or until duration of the at least one of the charge cycle and discharge cycle has lasted longer than a time period.

### Step c)

This step corresponds to step 203 in fig. 2 and step 304 in fig. 3. The battery management system 105 calculates a correction factor defined as a ratio between the uncalibrated charge capacity and the theoretical charge capacity.
Steps a) to c) may be carried out for N at least one of: the discharge cycle and the charge cycle.

### Step d)

This step may correspond to step 203 in fig. 2. The battery management system 105 may calculate an accumulated correction factor based on the calculated correction factor in each cycle of the N at least one of the discharge cycle and the charge cycle.
The accumulated correction factor may be calculated by using a filter. The filter may be a linear filter or a non-linear filter.

### Step e)

This step corresponds to step 204 in fig. 2. The battery management system 105 calibrates the current sensor 103 by adjusting a current sensor gain by means of the calculated correction factor.
The current sensor gain may be adjusted in step e) by means of the accumulated correction factor.
The present disclosure relates to a battery management system 105 for calibrating a current sensor 103.
The battery management system 105 is adapted to, e.g. by means of an obtaining unit, obtain an uncalibrated charge capacity from the current sensor 103 when it is uncalibrated. The uncalibrated charge capacity comprises at least one of current outflow from or current inflow to at least one battery cell 101 during at least one discharge cycle or charge cycle of the at least one battery cell 101. The obtaining unit may be the processor of the battery management system 105 or comprised in the processor of the battery management system 105.
The discharge cycle may be discharge of the at least one cell 10) to a second charge level, and the charge cycle may be charge of the at least one battery cell 101 to a first charge level, wherein the first charge level is higher than the second charge level.
The uncalibrated charge value may be obtained until a battery cell charge is lower than a known cell charge or until duration of at least one of the charge cycle or discharge cycle has lasted longer than a time period.
Obtaining of the uncalibrated charge capacity may be initiated when the current outflow or inflow obtained from the current sensor 103 is below a predetermined value during a predetermined time interval.
The battery management system 105 is adapted to, e.g. by means of the obtaining unit, obtain a theoretical charge capacity from known cell capacity characteristics of the at least one battery cell 101 during at least one discharge cycle or charge cycle. The known cell capacity characteristics may comprise at least one of:

*    a known cell charge capacity,
*    a known cell discharge capacity,

- a cell voltage versus cell discharged charge in a range between a first charge level and a second charge level, wherein the first charge level is higher than the second charge level, and
- a cell voltage versus cell charged charge in a range between the second charge level and the first charge level.

The theoretical charge capacity may be a charge capacity obtained from the known cell characteristics as an amount of charge discharged from the at least one battery cell 101 from the first charge level to the second charge level, or as an amount of charge charged to the at least one battery cell 101 from the second charge level and to the first charge level.

The theoretical charge value may be obtained until a battery cell charge is lower than a known cell charge or until duration of the at least one of the charge cycle and discharge cycle has lasted longer than a time period.

The uncalibrated charge capacity and the theoretical charge capacity may be obtained for N at least one of: the discharge cycle and the charge cycle.

The battery management system 105 is adapted to, e.g. by means of a calculating unit, calculate a correction factor defined as a ratio between the uncalibrated charge capacity and the theoretical charge capacity. The calculating unit may be the processor of the battery management system 105 or comprised in the processor of the battery management system 105.

The battery management system 105 is adapted to, e.g. by means of a calibrating unit, calibrate the current sensor 103 by adjusting a current sensor gain by means of the calculated correction factor. The calibrating unit may be the processor of the battery management system 105 or comprised in the processor of the battery management system 105. The current sensor gain may be adjusted by means of the accumulated correction factor.

The battery management system 105 may be adapted to, e.g. by means of a calculating unit, calculate an accumulated correction factor based on the calculated correction factor in each cycle of the N at least one of the discharge cycle and the charge cycle. The calculating unit may be the processor of the battery management system 105 or comprised in the processor of the battery management system 105. The accumulated correction factor may be calculated by using a filter, and the filter may be a linear filter or a non-linear filter.

A battery system 100 comprises the battery management system 105, at least one battery cell 101 and a current sensor 103.

The battery system 100 may comprise a plurality of battery cells 101. The plurality of battery cells 101 may be comprised in one or multiple battery modules 101 which are serially connected. Each of the plurality of battery cells 101 may be connected to the battery management system 105. One of the pluralities of battery cells 101 may be connected to the current sensor 103. The uncalibrated charge capacity and the theoretical charge capacity may be for the plurality of battery cells 101.

A computer program may comprise instructions which, when executed on at least one processor, cause the at least one processor to carry out the method as described herein. The processor may be the battery management system 105 or comprised in the battery management system 105. The computer program may comprise instructions to cause the battery management system 105 to execute the method described above.

A carrier may comprise the computer program, and the carrier may be of an electronic signal, optical signal, radio signal or computer readable storage medium.

Calibration of a current sensor 103 and associated dependent measurement paths are often needed to achieve sufficient SOC accuracy or sufficient accuracies in other current dependent estimates. This is often costly takes time. If the current sensor 103 used has some base accuracy, then the present disclosure can avoid a production type calibration entirely. The accuracy reached in this type of method is never better than the known cell charge capacity, but this is often exactly what is needed.

Summarized, the present disclosure relates to calibrating an uncalibrated current sensor 103 by using for example the known charge accuracy in the at least one battery cell 101, e.g. mounted in the battery module 108.

Various alternatives, modifications and equivalents to the present disclosure may be used. Therefore, the above description should not be taken as limiting. A feature may be combined with one or more other features.

The term "at least one of A and B" should be understood to mean "only A, only B, or both A and B.", where A and B are any parameter, number, indication used herein etc.

It should be emphasized that the term "comprises/comprising" when used herein is taken to specify the presence of stated features, integers, steps or components, but does not preclude the presence or addition of one or more other features, integers, steps, components or groups thereof. It should also be noted that the words "a" or "an" preceding an element do not exclude the presence of a plurality of such elements.

The term "configured to" used herein may also be referred to as "arranged to", "adapted to", "capable of" or "operative to".

It should also be emphasised that the steps of the methods may be performed in another order than the order in which they appear.

**Claims**

1. Method performed by a battery management system (105) for calibrating a current sensor (103), the method comprising:

    a) *obtaining* (201) an uncalibrated charge capacity from the current sensor (103) when it is uncalibrated, wherein the uncalibrated charge value comprises at least one of current outflow from or current inflow to at least one battery cell (101) during at least one discharge cycle or charge cycle of the at least one battery cell (101);
    b) *obtaining* (202) a theoretical charge capacity from known cell capacity characteristics of the at least one battery cell (101) during at least one discharge cycle or charge cycle;
    c) *calculating* (203, 304) a correction factor defined as a ratio between the uncalibrated charge capacity and the theoretical charge capacity; and
    e) *calibrating* (204) the current sensor (103) by adjusting a current sensor gain by means of the calculated correction factor.

2. The method according to claim 1, wherein the known cell capacity characteristics comprises at least one of:

    • a known cell charge capacity,
    • a known cell discharge capacity,
    • a cell voltage versus cell discharged charge in a range between a first charge level and a second charge level, wherein the first charge level is higher than the second charge level, and
    • a cell voltage versus cell charged charge in a range between the second charge level and the first charge level.

3. The method according to either of claims 1-2, wherein the discharge cycle in step a) is discharge of the at least one cell (101) to a second charge level, and wherein the charge cycle is charge of the at least one battery cell (101) to a first charge level, wherein the first charge level is higher than the second charge level, and
wherein the theoretical charge capacity in step b) is a charge capacity obtained from the known cell characteristics as an amount of charge discharged from the at least one battery cell (101) from the first charge level to the second charge level, or as an amount of charge charged to the at least one battery cell (101) from the second charge level and to the first charge level.

4. The method according to any one of the preceding claims, wherein steps a) to c) are carried out for N at least one of: the discharge cycle and the charge cycle,
and wherein the method further comprises:
d) *calculating* (203) an accumulated correction factor based on the calculated correction factor in each cycle of the N at least one of the discharge cycle and the charge cycle, and wherein the current sensor gain is adjusted in step e) by means of the accumulated correction factor.

5. The method according to claim 4, wherein the accumulated correction factor is calculated by using a filter, and wherein the filter is a linear filter or a non-linear filter.

6. The method according to any of the preceding claim, wherein the uncalibrated charge value is obtained until a battery cell charge is lower than a known cell charge or until duration of at least one of the charge cycle or discharge cycle has lasted longer than a time period.

7. The method according to any of the preceding claim, wherein the theoretical charge value is obtained until a battery cell charge is lower than a known cell charge or until duration of the at least one of the charge cycle and discharge cycle has lasted longer than a time period.

8. The method according to any of the preceding claims, wherein step a) is initiated when the current outflow or inflow obtained from the current sensor (103) is below a predetermined value during a predetermined time interval.

9. A battery management system (105) for calibrating a current sensor (103), the battery management system (105) being adapted to:

    a) obtain an uncalibrated charge capacity from the current sensor (103) when it is uncalibrated, wherein the uncalibrated charge capacity comprises at least one of current outflow from or current inflow to at least one battery cell (101) during at least one discharge cycle or charge cycle of the at least one battery cell (101);

b) obtain a theoretical charge capacity from known cell capacity characteristics of the at least one battery cell (101) during at least one discharge cycle or charge cycle;

c) calculate a correction factor defined as a ratio between the uncalibrated charge capacity and the theoretical charge capacity; and to

d) calibrate the current sensor (103) by adjusting a current sensor gain by means of the calculated correction factor.

10. A battery system (100) comprising the battery management system (105) of claim 9, at least one battery cell (101) and a current sensor (103)

11. The battery system (100) according to claim 10, wherein the battery system (100) comprises a plurality of battery cells (101),

wherein the plurality of battery cells (101) are comprised in one or multiple battery modules (101) which are serially connected,

wherein each of the plurality of battery cells (101) are connected to the battery management system (105),

wherein one of the plurality of battery cells (101) is connected to the current sensor (103), and wherein the uncalibrated charge capacity and the theoretical charge capacity are for the plurality of battery cells (101).

12. A computer program comprising instructions which, when executed on at least one processor, cause the at least one processor to carry out the method according to any one of claims 1-8.

13. A carrier comprising the computer program of claim 12, wherein the carrier is one of an electronic signal, optical signal, radio signal or computer readable storage medium.

EP 3 879 619 A1

100

```
┌─────────────┐      ┌─────────────┐      ┌─────────────────┐
│    101.     │      │    103.     │      │  105. Battery   │
│   Battery   │──────│   Current   │──────│   Management    │
│    cell     │      │   sensor    │      │     System      │
└──────┬──────┘      └─────────────┘      │                 │
       │                                   │                 │
       └───────────────────────────────────┤                 │
                                           └─────────────────┘
```

106

**Fig. 1a**

Fig. 1b

201. Obtain an uncalibrated charge capacity

202. Obtain a theoretical charge capacity

203. Calculate a correction factor

204. Calibrate the current sensor

Fig. 2

Start

301. Charge battery
cell to first charge level

302. Zero current
integration

303. Do charge
integration

304.
Vcell<VcellFirst
ChargeLevel?

305. Calculate
correction factor

Fig.3

Fig. 4

EP 3 879 619 A1

Europäisches
Patentamt

European
Patent Office

Office européen
des brevets

# EUROPEAN SEARCH REPORT

**Application Number**

EP 20 16 2438

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2015 224975 A (CALSONIC KANSEI CORP) 14 December 2015 (2015-12-14)<br><br>* abstract; figures 1-4 *<br>* paragraphs [0001] - [0018], [0025] - [0029], [0036], [0040] - [0045] *<br>* Formulas: 1-6 *<br>----- | 1-3, 6-10,12, 13 | INV.<br>H01M10/42<br>H01M10/44<br>G01R31/36<br><br>ADD.<br>G01R35/04<br>G01R35/00 |
| X | US 2020/033416 A1 (TAKEGAMI TOMOKI [JP] ET AL) 30 January 2020 (2020-01-30)<br>* abstract *<br>* paragraphs [0034], [0045] - [0061], [0065] - [0068], [0073], [0088] - [0093], [0134] *<br>----- | 1,4,5, 9-13 | |
| X | CN 108 226 809 A (HUAIYIN INST TECHNOLOGY) 29 June 2018 (2018-06-29)<br>* abstract; figures 1-6 *<br>* paragraphs [0006] - [0008], [0019] - [0029], [0032], [0040], [0067] - [0075], [0081], [0090] - [0106] *<br>----- | 1,4,5 | |

**TECHNICAL FIELDS SEARCHED (IPC)**

H01M
G01R

The present search report has been drawn up for all claims

| Place of search | Date of completion of the search | Examiner |
|---|---|---|
| The Hague | 17 September 2020 | Chmela, Emil |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 16 2438

This annex lists the patent family members relating to the patent documents cited in the above-mentioned European search report.
The members are as contained in the European Patent Office EDP file on
The European Patent Office is in no way liable for these particulars which are merely given for the purpose of information.

17-09-2020

| Patent document cited in search report | | Publication date | Patent family member(s) | | Publication date |
|---|---|---|---|---|---|
| JP 2015224975 | A | 14-12-2015 | NONE | | |
| US 2020033416 | A1 | 30-01-2020 | CN | 110506216 A | 26-11-2019 |
| | | | EP | 3605121 A1 | 05-02-2020 |
| | | | JP | WO2018179562 A1 | 09-01-2020 |
| | | | US | 2020033416 A1 | 30-01-2020 |
| | | | WO | 2018179562 A1 | 04-10-2018 |
| CN 108226809 | A | 29-06-2018 | NONE | | |

EPO FORM P0459

For more details about this annex : see Official Journal of the European Patent Office, No. 12/82